(19) Europäisches Patentamt / European Patent Office / Office européen des brevets

(11) **EP 3 082 390 B1**

(12) **EUROPEAN PATENT SPECIFICATION**

(45) Date of publication and mention
of the grant of the patent:
**08.01.2020 Bulletin 2020/02**

(21) Application number: **15748479.1**

(22) Date of filing: **12.02.2015**

(51) Int Cl.:
*H05K 13/04* (2006.01)          *H05K 13/08* (2006.01)
*B25J 15/06* (2006.01)          *G01L 1/16* (2006.01)
*G01L 5/00* (2006.01)

(86) International application number:
**PCT/JP2015/053800**

(87) International publication number:
**WO 2015/122449 (20.08.2015 Gazette 2015/33)**

(54) **COMPONENT MOUNTING DEVICE AND DETECTION DEVICE**

KOMPONENTENMONTAGEVORRICHTUNG UND DETEKTIONSVORRICHTUNG

DISPOSITIF DE MONTAGE DE COMPOSANT, ET DISPOSITIF DE DÉTECTION

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **12.02.2014 JP 2014023967**

(43) Date of publication of application:
**19.10.2016 Bulletin 2016/42**

(73) Proprietor: **Yamaha Hatsudoki Kabushiki Kaisha
Iwata-shi, Shizuoka-ken 438-8501 (JP)**

(72) Inventors:
• **KOIDE, Akira
Tokyo 100-8280 (JP)**

• **OKAMOTO, Yoshinori
Shizuoka-ken 438-8501 (JP)**

(74) Representative: **Müller-Boré & Partner
Patentanwälte PartG mbB
Friedenheimer Brücke 21
80639 München (DE)**

(56) References cited:
**GB-A- 2 239 856          JP-A- 2000 022 396
JP-A- 2005 019 957      JP-A- 2006 261 367
JP-A- 2009 192 335      JP-A- 2012 174 751
US-A- 5 285 946          US-A1- 2009 199 658
US-B1- 6 178 621**

## Description

## Technical Field

The present invention relates to a system for conveying a component and a detection device. Particularly, the present invention relates to a detection device that detects a force and a component mounting device for mounting a component to a substrate.

## Background Art

At production sites, suction conveyance devices for handling small electronic components or the like and various forms of production equipment mounted with the same are utilized. A component mounting device is an example of such production equipment and is a device for mounting a component to a substrate. Patent Literature 1 to 3 below can be given as prior art documents.

A component mounting device of Patent Literature 1 includes a servomotor that positions the height of a nozzle onto which an electronic component is suctioned and a pressurization control head that can control the load by which the component suctioned onto the nozzle is pressed against a substrate. The servomotor is utilized also as a pressurization source to pressurize the nozzle such that the component is pressed against the substrate by the nozzle. The pressure of the pressurization is made variable depending on the generated output torque of the servomotor that is caused by the difference of a command level logical coordinate and an actual coordinate of the servomotor. Accordingly, damage to a component or errors such as an attachment failure is prevented. In Patent Literature 1, a strain gauge is used as a sensor that detects the pressure force on a component. Generally, a strain gauge is too great in size and weight to be attached to a nozzle that operates at high speed. Therefore, the strain gauge is attached in a beam portion coupling the servomotor and a movable portion to which the nozzle is attached.

However, along with size reduction of electronic components, it has become necessary to make minute the impact force (pressure force) for landing an electronic component on a land of a substrate without causing damage. In the case of attempting to detect a minute impact force, detection of the minute impact force is difficult with a structure in which a strain gauge is installed in the beam portion apart from a suction nozzle as in the component mounting device of Patent Literature 1, due to disturbance such as inertia force of the movable portion.

## Citation List

## Patent Literature

Patent Literature 1: Japanese Unexamined Patent Publication No. 2012-174751
-Patent Literature 2: Japanese Unexamined Patent Publication No. H5-288618
Patent Literature 3: Japanese Unexamined Patent Publication No. H5-304395

US 5 285 946 A discloses an apparatus for mounting electronic components on the surface of printed boards.

US 2009/199658 A1 discloses a load detection device which includes a piezoelectric body unit adapted to be deformed by receiving an electric voltage.

## Summary of Invention

An object of the present invention is to provide a detection device that can accurately detect landing of a component with respect to a land of a substrate and a component mounting device using the same.

A component mounting device according to one aspect of the present invention is defined in claim 1.

One feature of the present invention is that landing of a component is detected utilizing a piezoelectric body (piezoelectric film). For the present invention, attention has been directed to an impact force upon a component landing on a land of a substrate being a force applied for a short period of time. The piezoelectric film is utilized as a press sensor that detects a minute impact force buffered by a buffer spring equipped in a suction nozzle. The piezoelectric film has a small size and low mass that allow incorporation in a buffer-spring-equipped suction nozzle, which is a consumable, or the tip end of a drive shaft to which the same is attached, and generates an electric charge proportional to the differential of the applied force.

An object, feature, and advantage of the present invention will become clearer with the following detailed description and the accompanying drawings.

## Brief Description of Drawings

Figs. 1A to 1E are views illustrating steps of attaching an electronic component to a land of a substrate.
Fig. 2 is a view illustrating an example in which an electronic component has been attached in a state of excessive pushing into a land.
Fig. 3A is a view showing an example in which an electronic component has been attached in a state of insufficient pushing into a land, and Fig. 3B is a view illustrating a defect due to the insufficient pushing.
Fig. 4A is an upper view of a press sensor of Embodiment 1, and Fig. 4B is a sectional view along line IVB-IVB of Fig. 4A.
Fig. 5A is an upper view of a press sensor of Embodiment 2, and Fig. 5B is a sectional view along line VB-VB of Fig. 5A.

Fig. 6A is an upper view of a press sensor of Embodiment 3, and Fig. 6B is a sectional view along line VIB-VIB of Fig. 6A.

Figs. 7A and 7B are views illustrating the effect of a pressing section.

Fig. 8 is a chart illustrating the effect of a pressing jig.

Fig. 9A is an upper view of a press sensor of Embodiment 4, and Fig. 9B is a sectional view along line IXB-IXB of Fig. 9A.

Figs. 10A and 10B are views illustrating the effect of a pressing relief section.

Fig. 11 is a view schematically showing a component mounting device of Embodiment 5.

Fig. 12 is a sectional view illustrating the details of a suction conveyance device.

Fig. 13 is an exploded sectional view illustrating the details of a suction nozzle attachment/detachment section.

Fig. 14 is a sectional view illustrating a method of assembling the suction nozzle attachment/detachment section.

Fig. 15 is a block diagram schematically showing peripheral devices for operating the suction conveyance device.

Fig. 16 is a flowchart of component mounting.

Fig. 17 is a timing chart showing the relation of the speed of a suction nozzle and the output from a press sensor with respect to time.

Fig. 18 is a view illustrating $H_1$ $H_2$, $\Delta H$, $N_{h1}$, $N_0$, and $N_{h2}$.

Fig. 19 is a flowchart for illustrating Embodiment 6.

Fig. 20 is a side view of a suction conveyance device according to Embodiment 7.

**Description of Embodiments**

Embodiments of the present invention will be described below. The descriptions below are for a clear explanation to those skilled in the art and not intended to particularly limit the present invention. Hereinafter, the horizontal direction will be referred to as XY-direction, and the perpendicular direction Z-direction.

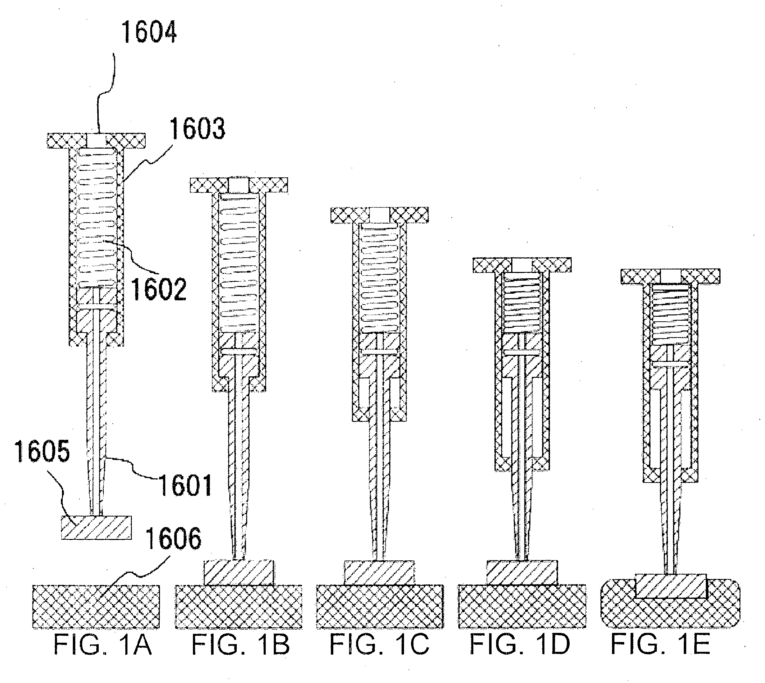

First, the first part of the technique of the present invention will be described. For component mounting devices, there are demands to improve productivity. One approach to improving productivity is speeding up the operation of a component mounting device. Figs. 1A to 1E show steps of attaching an electronic component 1605 to solder referred to as a land 1606 on a substrate in time order. In the first step 1A, the electronic component 1605 is suctioned onto a suction nozzle 1601 by a negative pressure supplied via a vacuum suction flow path 1604. The suction nozzle 1601 moves to convey the electronic component 1605 onto the land 1606 of the substrate.

In the subsequent step IB, the suction nozzle 1601 is lowered in the Z-direction with a linear actuator, and the electronic component 1605 is landed on the land 1606. To the suction nozzle 1601, a buffer spring 1602 is connected. The buffer spring 1602 is for preventing the electronic component 1605 from being damaged by the impact force upon landing on the land 1606, when the lowering speed of the suction nozzle 1601 has been increased. The combination of the suction nozzle 1601 and the buffer spring 1602 can be expressed as a buffer-spring-equipped suction nozzle 1603.

In the subsequent steps 1C and 1D, the electronic component 1605 is pressed against the land 1606 by the suction nozzle 1601. The buffer spring 1602 is designed to be low in rigidity, so that the impact force of the suction nozzle 1601 is buffered to an extent of not damaging the electronic component 1605. Until the buffer spring 1602 is fully compressed, the electronic component 1605 remains in the landed position without hardly being pushed into the land 1606. Until full compression of the buffer spring 1602, the linear actuator decelerates the lowering speed of the suction nozzle 1601.

In the last step 1E, the suction nozzle 1601 pushes the electronic component 1605 into the land 1606 by a predetermined amount. The amount of pushing at this time is controlled using a method called assumption control. In the assumption control, the amount of warpage of the substrate fixed to a stage of the component mounting device is measured at several locations to estimate the warpage amount distribution in the entire substrate, and the heights of respective lands on the substrate are calculated. Then, the electronic component 1605 is landed on the land 1606 at an appropriate lowering speed, and, upon the electronic component 1605 being pushed into the land 1606 by the predetermined amount, the linear actuator for the Z-direction is stopped.

As described above, in a general component mounting device, problems such as damage to the electronic component 1605 are solved and the speed is increased, through the assumption control and the buffer-spring-equipped suction nozzle 1603. However, when the substrate size is increased in order to increase the mounting speed, error for the estimated value of land height and the actual land height increases, resulting in undesirable phenomena. One of the undesirable phenomena is a defect due to excessive pushing of the electronic component 1605 into the land 1606, and another is a defect due to insufficient pushing of the electronic component 1605 into the land 1606.

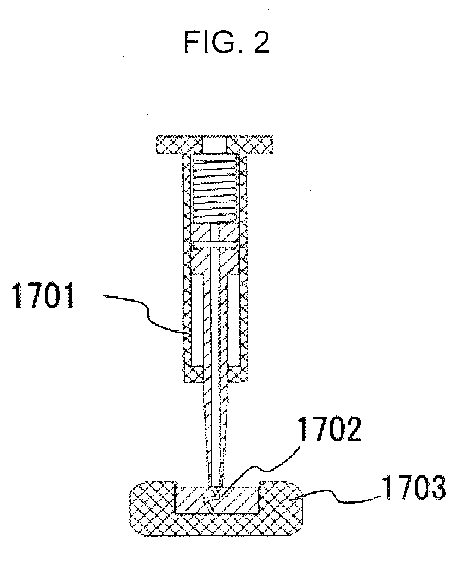

First, a defect due to excessive pushing will be described using Fig. 2. When excessive pushing of a suction nozzle 1701 occurs, as shown in Fig. 2, solder forming a land 1703 is spread out by a pushed electronic component 1702. As a result, short circuit with an adjacent electronic component occurs in some cases. Further, in cases where the land 1703 is thin in thickness, the electronic component 1702 is damaged in some cases by a large force being applied to the electronic component 1702.

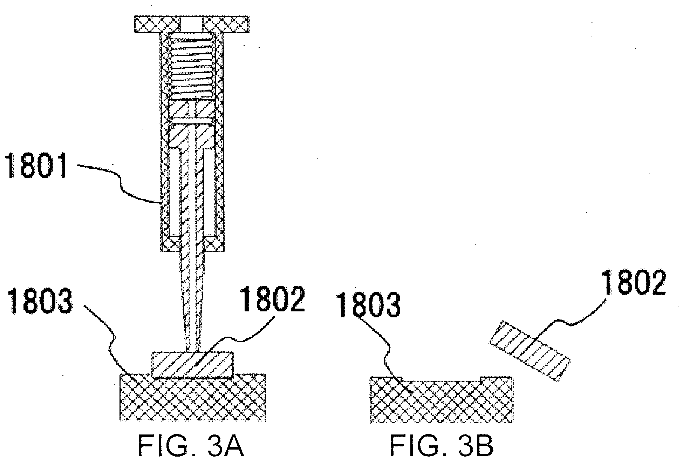

Next, a defect due to insufficient pushing will be described using Fig. 3. When insufficient pushing of a nozzle 1801 occurs, as shown in Fig. 3A, insufficient adhesion of a land 1803 and an electronic component 1802 occurs. As a result, a malfunction may occur in which the electronic component 1802 falls off the land 1803, as shown in Fig. 3B.

As such, the approach utilizing the assumption control and the buffer-spring-equipped suction nozzle is hardly an adequate approach with respect to an increase in substrate size. For a mounting defect caused by the difference of the estimated value of land height and the actual land height, a conceivable approach is to reduce the difference of the estimated value and the actual land height. It can be said that the component mounting device of Patent Literature 1 illustrated earlier corresponds to this approach. However, in view of the circumstance that size reduction of electronic components is making progress, measures need to be taken to make the impact force (pressure force) minute for landing an electronic component on a land of a substrate without causing damage. The present invention addresses such demand.

Embodiments of the present invention will be described below using the drawings. Deletion, mutual substitution, and combination are possible for parts of the configurations of the respective embodiments. The present invention is not construed as limiting to the embodiments, and the structure or the like of a conveyance device or component mounting device may be a structure other than those described in the embodiments. A component is a broad expression including not only electronic components, but also food products and biological samples.

In Embodiments 1 to 4 below, a detection device that detects some kind of force will be described. In Embodiments 5 to 7, examples applying at least one of a component mounting device and a conveyance device to the detection device described in Embodiments 1 to 4 will be described.

<Embodiment 1>

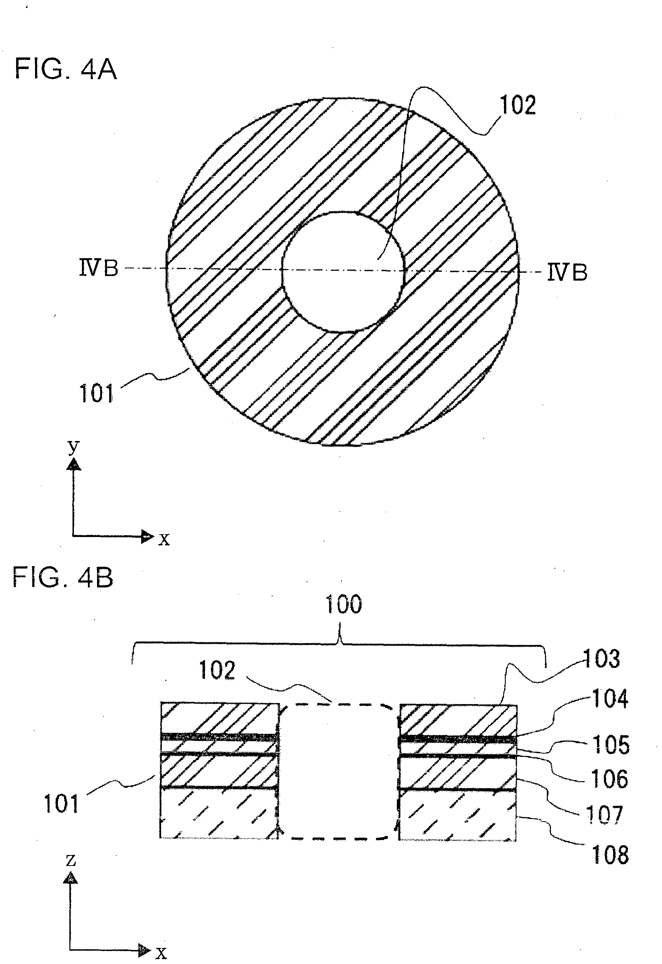

Fig. 4A is an upper view of a press sensor 100 of Embodiment 1, and Fig. 4B is a sectional view along line IVB-IVB of Fig. 4A. The press sensor 100 is an example of a detection device according to the present invention. In the press sensor 100, a high-rigidity plate 108 that counteracts the force received by the press sensor 100 is arranged. On the high-rigidity plate 108, two low-rigidity plates 103 and 107 with a lower rigidity than the high-rigidity plate 108 are arranged. Within the press sensor 100, a laminated structure is formed in which a piezoelectric film 105, an example of a piezoelectric body, is arranged between the low-rigidity plate 103 and the low-rigidity plate 107. The low-rigidity plate 107, the high-rigidity plate 108, and the low-rigidity plate 103 are respectively examples of a first plate, a second plate, and the first plate according to the present invention.

For the material of the piezoelectric film 105, any piezoelectric material with approximately 0.3 to 2 GPa of shear modulus of elasticity G can be employed, such as at least one of polyvinylidene fluoride, a vinylidene fluoride-tetrafluoroethylene copolymer, and a vinylidene fluoride-trifluoroethylene copolymer.

An upper electrode 104 and a lower electrode 106 are respectively formed on the upper surface and the lower surface of the piezoelectric film 105. It is possible to form films of the upper electrode 104 and the lower electrode 106 respectively on both surfaces of the piezoelectric film 105, using a film-forming technique such as sputtering or vapor deposition. As other film-forming methods, a desirable method can be employed, such as a method of applying (printing) conductive paste or a method of laminating a metal foil.

The lower surface of the upper electrode 104 and the upper surface of the piezoelectric film 105 are in contact, and the upper surface of the lower electrode 106 and the lower surface of the piezoelectric film 105 are in contact. Further, the upper surface of the upper electrode 104 and the lower surface of the low-rigidity plate 103 are in contact, and the lower surface of the lower electrode 106 and the upper surface of the low-rigidity plate 107 are in contact. The lower surface of the low-rigidity plate 107 and the upper surface of the high-rigidity plate 108 are in contact. Such a structure can be expressed as a substantial laminated structure. The laminated structure is substantially a thin film of several tens of microns and is an extremely compact structure.

In the center of a press sensor pressure-receiving section 101, a hole 102 is provided. The hole 102 is for opening a flow path for generating a suction force through vacuuming, in a suction nozzle to which the press sensor 100 is attached.

When deformed by some kind of force, the piezoelectric film 105 generates an electric charge proportional to the speed of deformation. By applying the force causing the deformation only in the thickness direction of the piezoelectric film 105 (z-direction in Fig. 4B) and extracting the electric charge via the upper electrode 104 and the lower electrode 106, the laminated structure shown in Fig. 4 is made utilizable as a press sensor that detects only the force in the thickness direction of the piezoelectric film 105.

The piezoelectric film 105 can be treated as an incompressible material (material with general properties of a material having rubber elasticity), and a volume change hardly occurs even upon deformation by force. Therefore, when lateral deformation is completely restrained by the high-rigidity plate 108 or the like, the piezoelectric film 105 cannot deform in the thickness direction. Thus, in this embodiment, the low-rigidity plates 103 and 107 with a lower rigidity than the high-rigidity plate 108 are arranged on both sides of the piezoelectric film 105 to allow lateral deformation of the piezoelectric film 105.

The piezoelectric film 105, the low-rigidity plates 103 and 107, and the high-rigidity plate 108 may be laminated without bonding or may be laminated with bonding. It suffices that the piezoelectric film 105, the low-rigidity plates 103 and 107, and the high-rigidity plate 108 be substantially laminated. In the case of mere lamination without bonding, a state is desirable in which contacts are made without gaps between layers through constant application of surface pressure.

In the press sensor 100 of this embodiment, the piezoelectric film 105 generates an electric charge proportional to the speed of deformation caused by an external force. The electric charge is extracted by the upper electrode 104 and the lower electrode 106 arranged on the upper and lower surfaces of the piezoelectric film 105. Based on a signal (first signal) generated by the electric charge, the press sensor 100 detects a minute impact force generated upon landing of an electronic component on a land.

A sensor output using the piezoelectric film 105 has properties of being dependent on the rate of change in force at the moment the electronic component has landed on the land, but hardly dependent on the pressure-receiving area of the piezoelectric film 105 for detection. Therefore, it is suitable for size reduction.

Further, the piezoelectric film 105 as a sensing element is a thin resin and therefore lightweight, hardly changes the mass of a movable section even when incorporated in a suction nozzle, and does not interfere with increasing the speed of operation of the suction nozzle. Since an electric charge generated by the piezoelectric film 105 being pressed is utilized, a power supply is unnecessary, and load on a power supply does not increase even when a sensor is incorporated in all of a plurality of suction nozzles provided to an electronic component mounting machine.

Further, regarding control as well, as will be described later in detail, a robust control system with respect to disturbances can be formed by controlling at least one of the lowering speed and stopping position of a suction nozzle based on a pulsed output emitted by the press sensor 100 with respect to an impact force.

By applying the press sensor 100 of this embodiment to a component mounting device, it is possible to optimize the amount of pushing of an electronic component into a land without sacrificing the high speed of operation of a suction nozzle, and a system of high productivity that avoids defects due to excessive pushing or insufficient pushing can be provided. With the use of an integrating circuit, it is also possible to measure the pressing force of an electronic component on a land, making it also possible to mount an electronic component with an optimum pressing force.

<Embodiment 2>

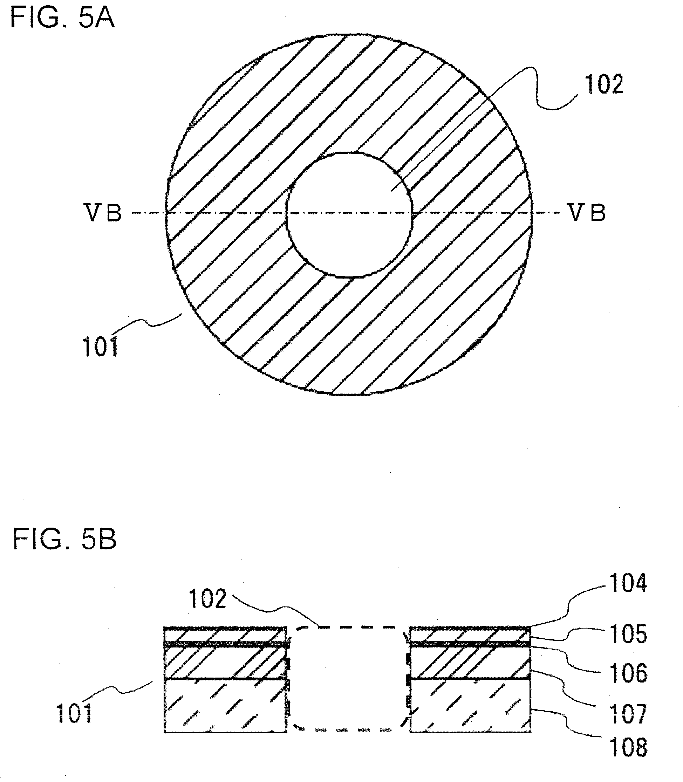

Next, Embodiment 2 will be described using Fig. 5. Fig. 5A is an upper view of a press sensor of Embodiment 2, and Fig. 5B is a sectional view along line VB-VB of Fig. 5A. In the description below, portions differing from other embodiments will be described. Structures shown in Embodiment 2 to Embodiment 4 can also be expressed as a substantial laminated structure.

The difference from Embodiment 1 is that the low-rigidity plate 103 on the upper electrode 104 side of the piezoelectric film 105 is not present. In this embodiment, the upper surface of the piezoelectric film 105 is a free surface. Therefore, in the case where restraint in the lateral direction by a pressing jig transmitting the force from a suction nozzle to the piezoelectric film 105 is weak, it is possible to increase the output relative to a case where the low-rigidity plate 103 is present.

Note that, since the force is applied directly to the upper electrode 104 of the piezoelectric film 105, there is in some cases a disadvantage against Embodiment 1 in terms of durability of the electrode. Thus, for the material forming the upper electrode 104 in Embodiment 2, it is preferable to use a material with higher durability than the material forming the upper electrode 104 of Embodiment 1.

<Embodiment 3>

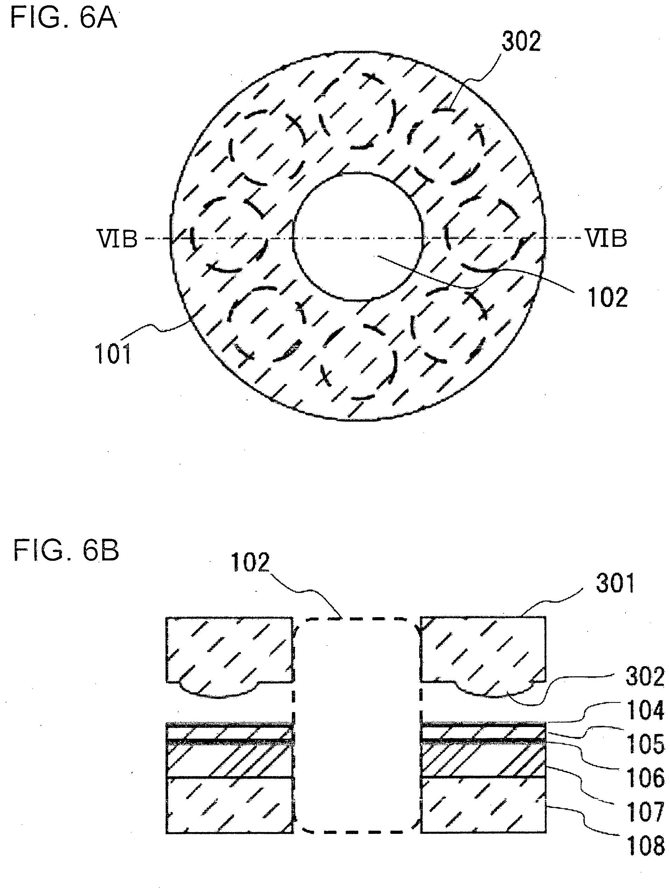

Next, Embodiment 3 will be described using Fig. 6. Fig. 6A is an upper view of a press sensor of Embodiment 3, and Fig. 6B is a sectional view along line VIB-VIB of Fig. 6A. This embodiment is an embodiment that can increase the output of the press sensor, compared to a case of pressing the entire surface of the piezoelectric film 105 on the upper electrode 104 side. As mentioned earlier, the piezoelectric film 105 hardly changes in volume upon deformation. Therefore, when the area of a freely-deforming surface is small with respect to a pressure-receiving surface that receives the force from a suction nozzle, the apparent Young's modulus E of the piezoelectric film 105 increases.

An approximation formula (Hattori-Takei formula) using an energy method for a case where the pressure-receiving surface is circular is shown below. The approximation formula is fairly consistent with experiment results when the shape coefficient S is less than 20.

$$E = G \times (3 + 4.94 \times S^2),$$

where S (which equals pressure-receiving area over free surface area) denotes the shape coefficient, and G denotes the shear modulus of elasticity in GPa.

With this approximation formula, consider a case where the piezoelectric film 105 is attached to a suction nozzle section, and where the force from a suction nozzle has transmitted to the entire surface of the piezoelectric film 105 via a flat surface. Assuming that rigidities of the piezoelectric film 105 and the low-rigidity plate 103 are the same, the width of the laminated structure is $\phi$5 mm, the thickness is 0.08 mm, and the center hole size is $\phi$3 mm, S is 6.25, and the apparent Young's modulus E is approximately 65 times the original Young's modulus of the piezoelectric film 105. In this case, even with the same impact force received, the amount of deformation, i.e., sensor output, obtained is only less than 2% of the value calculated from the original Young's modulus of the piezoelectric film 105. Thus, the apparent Young's modulus is desirably small.

The press sensor of Embodiment 3 includes a pressing jig 301 arranged on the upper electrode 104 and a pressing section 302 provided to the lower surface of the pressing jig 301. The pressing section 302 is provided to reduce the shape coefficient S, so that the apparent Young's modulus is reduced. The pressing section 302 presses a part of the piezoelectric film 105. That is, the force from the suction nozzle is transmitted to the piezoelectric film 105 via the pressing section 302.

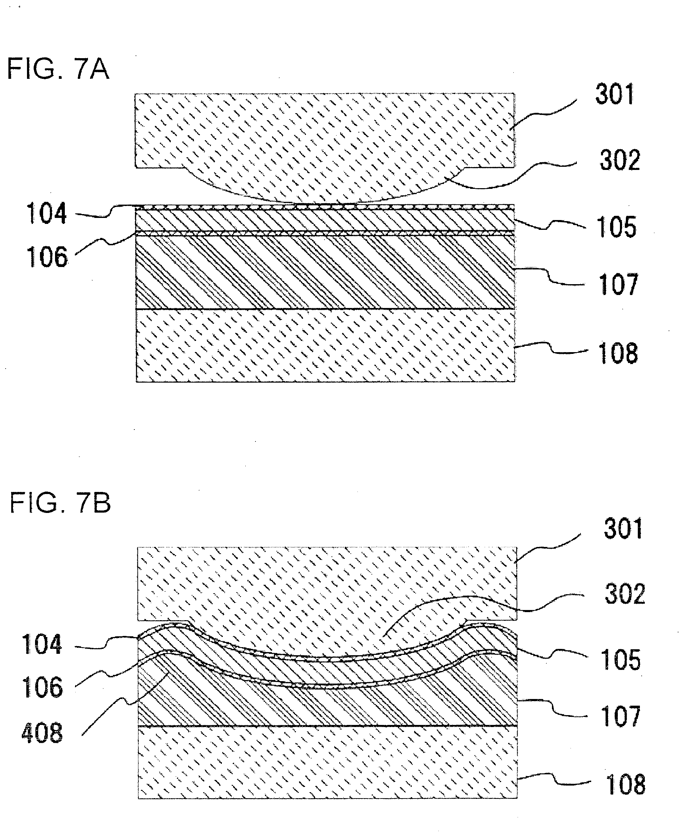

The effect of the pressing section 302 herein will be described, based on Figs. 7A and 7B. The piezoelectric film 105 receives the force applied to the suction nozzle from the upper electrode 104 side. In the case where the piezoelectric film 105 receives the force with the entire surface, the piezoelectric film 105, being treated as an incompressible material as mentioned earlier, cannot deform when restrained at upper and lower surfaces, except to expand at an outer circumference section. Therefore, as mentioned earlier, the output is one sixty-fifth of the value calculated from the original Young's modulus of the piezoelectric film 105.

Thus, in this embodiment, the configuration is such that, when the force from the suction nozzle is applied to the piezoelectric film 105, the pressing section 302 of the pressing jig 301 pushes a part of the piezoelectric film 105 as shown in Fig. 7A, so that the piezoelectric film 105 can deform. With a portion of the piezoelectric film 105 that has been pressed and deformed moving to a deformation flow section 408 as shown in Fig. 7B, an increase in the apparent Young's modulus of the piezoelectric film 105 is prevented. The pressing section 302 is a projection for pushing the piezoelectric film 105.

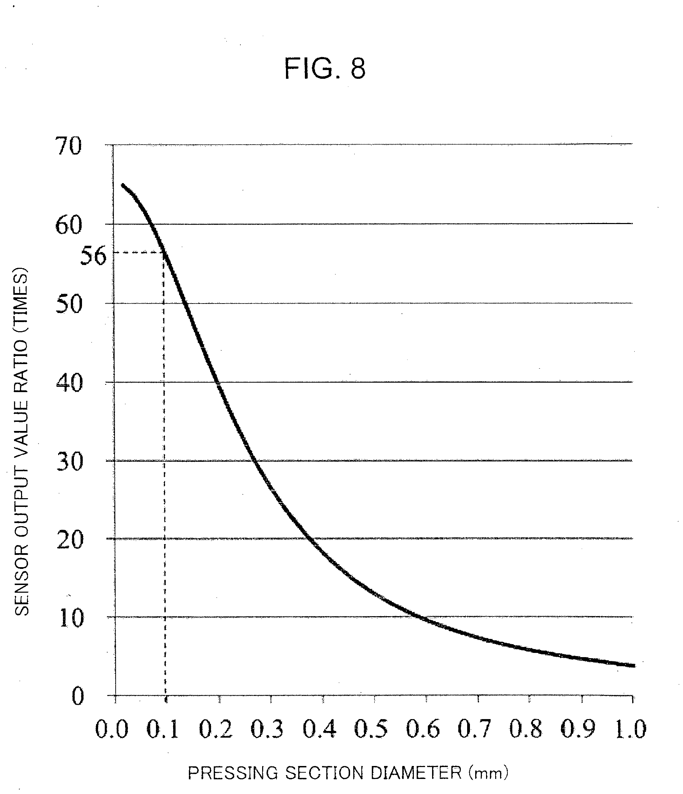

The effect of the pressing jig 301 is shown in Fig. 8. The abscissa of Fig. 8 denotes the diameter of the pressing section 302, and the ordinate the sensor output value ratio. The sensor output value ratio shows the ratio of a sensor output in the case of partially pressing the piezoelectric film 105 using the pressing jig 301, with respect to a sensor output in the case of pushing the entire surface of the piezoelectric film 105. As can be seen from Fig. 8, the sensor output is approximately 56 times as much when the diameter of the pressing section 302 is 0.1 mm. Thus, it can be understood that, by reducing the diameter of the pressing section 302, the output of the sensor approaches the output value of a case where the shape of the piezoelectric film 105 is not considered.

The output of the piezoelectric film 105 increases, as the amount of deformation increases. As a method of increasing the amount of deformation, a method of reducing the original Young's modulus is conceivable, besides a method of preventing an increase in the apparent Young's modulus caused by the shape as mentioned above. For the material of the piezoelectric film 105, in the method of reducing the original Young's modulus, a material with approximately 0.3 to 2 GPa of shear modulus of elasticity G is used, such as polyvinylidene fluoride, a vinylidene fluoride-tetrafluoroethylene copolymer, or a vinylidene fluoride-trifluoroethylene copolymer. Since materials of which the original Young's modulus is small are limited in this manner, a rubber sheet softer than the piezoelectric film 105 can be employed as a low-rigidity plate in this embodiment.

As an example, a case of using a silicone rubber sheet as a low-rigidity plate will be shown. The shear modulus of elasticity G of a silicone rubber sheet is approximately 4 to 40 MPa, which is smaller than of the piezoelectric film 105 by two digits. Therefore, it is possible to increase the sensor output. The sensor output is approximately 1.2 times as much when the thicknesses of respective layers in this case are 0.03 mm for a piezoelectric film and 0.07 mm for the silicone rubber sheet, and approximately 5 times as much when the thickness of the silicone rubber sheet is 0.12 mm.

The pressing section 302 in Fig. 6 and Fig. 7 of this embodiment has been described as being rounded in shape. The pressing section 302 may be in a cylindrical shape or in a shape other than a circle when seen from above, so long as the shape is protruded (in other words, a projection).

<Embodiment 4>

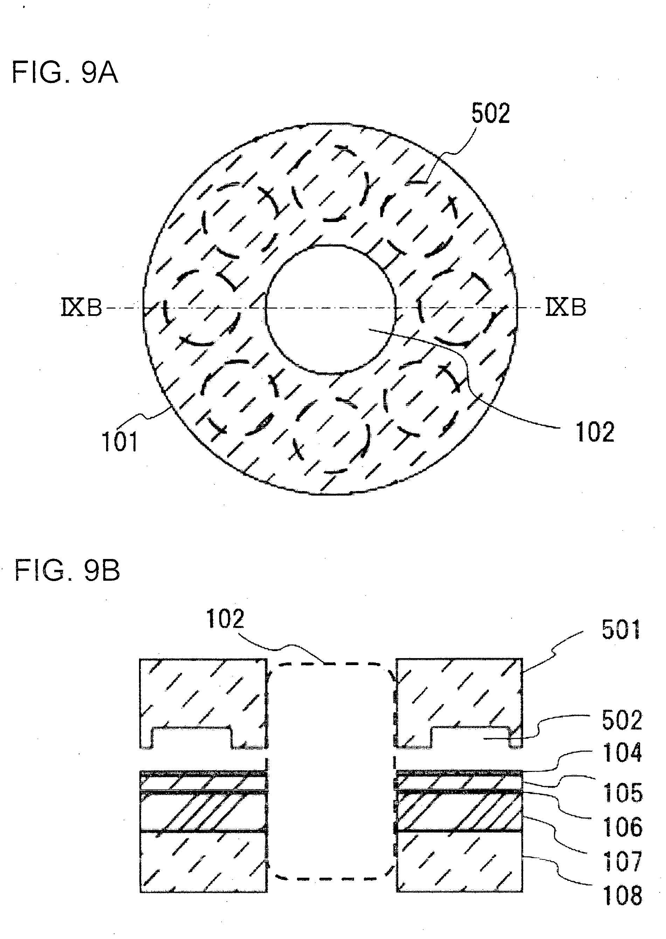

Next, Embodiment 4 will be described using Fig. 9. Fig. 9A is an upper view of a press sensor of Embodiment 4, and Fig. 9B is a sectional view along line IXB-IXB of Fig. 9A. This embodiment is an embodiment that can increase the output of the press sensor, compared to a case of pressing the entire surface of the piezoelectric film 105 on the upper electrode 104 side, in a similar manner to Embodiments 2 and 3.

The press sensor of Embodiment 4 includes a pressing jig 501 arranged on the upper electrode 104 and a pressing relief section 502 provided to the lower surface of the pressing jig 501. The pressing relief section 502 is a recess section indented upward from the lower surface of the pressing jig 501. The difference of this embodiment from Embodiment 3 is that, while the deformation flow section 408 has been formed around the pressing section 302 as shown in Fig. 7 in Embodiment 3, the function of the deformation flow section 408 is served by the pressing relief section 502 of the pressing jig 501 in this embodiment. This embodiment is advantageous in that processing of the pressing jig 501 is easier than in Embodiment 3.

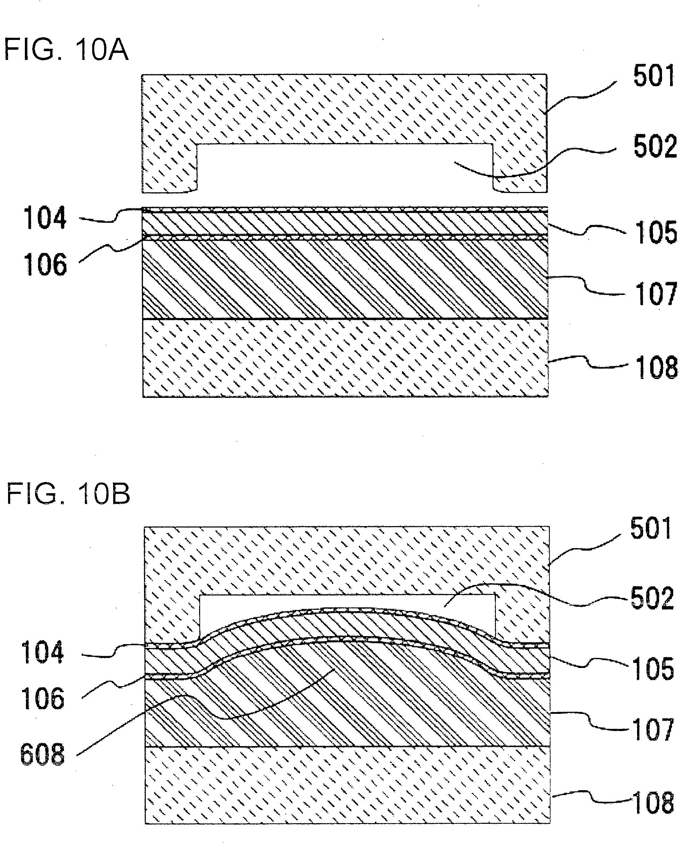

The effect of the pressing relief section 502 herein will be described using Figs. 10A and 10B in which the pressing relief section 502 is enlarged. Fig. 10A and Fig. 10B respectively show the state before the pressing jig 501 presses the piezoelectric film 105 and the state after pressing. When the piezoelectric film 105 is pushed by the pressing jig 501, a part of the piezoelectric film 105 (which can be expressed as a deformation movement section 608 herein) moves into the pressing relief section 502. In this embodiment, deformation of the piezoelectric film 105 is facilitated by this motion. The pressing relief section 502 is a recess for pushing the piezoelectric film 105. The pressing section 302 of Embodiment 3 and the pressing relief section 502 are in shapes for pushing a part of (partially pushing) the piezoelectric film 105.

<Embodiment 5>

Next, Embodiment 5 will be described. This embodiment is an example of applying the press sensor 100 described in Embodiments 1 to 4 to at least one of a conveyance device for holding and conveying a component and a component mounting device. At least one of the conveyance device and the component mounting device can be expressed as an example of a system for conveying some kind of component.

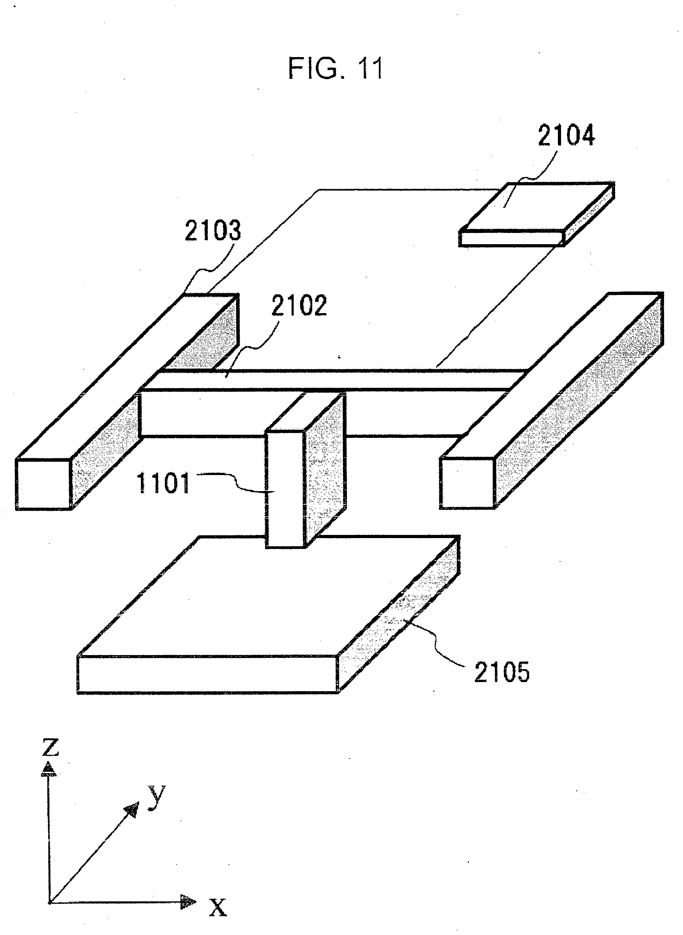

Fig. 11 is a view schematically showing the configuration of a component mounting device of this embodiment. The component mounting device of this embodiment includes a suction conveyance device 1101 for mounting a component to a substrate 2105, an x-beam 2102 for moving the suction conveyance device 1101 in the x-direction, a γ-beam 2103 for moving the x-beam 2102 in the γ-direction, and a processing unit 2104 for controlling the x-beam 2102, the γ-beam 2103, and the suction conveyance device 1101. The suction conveyance device 1101 is in some cases referred to as a head actuator.

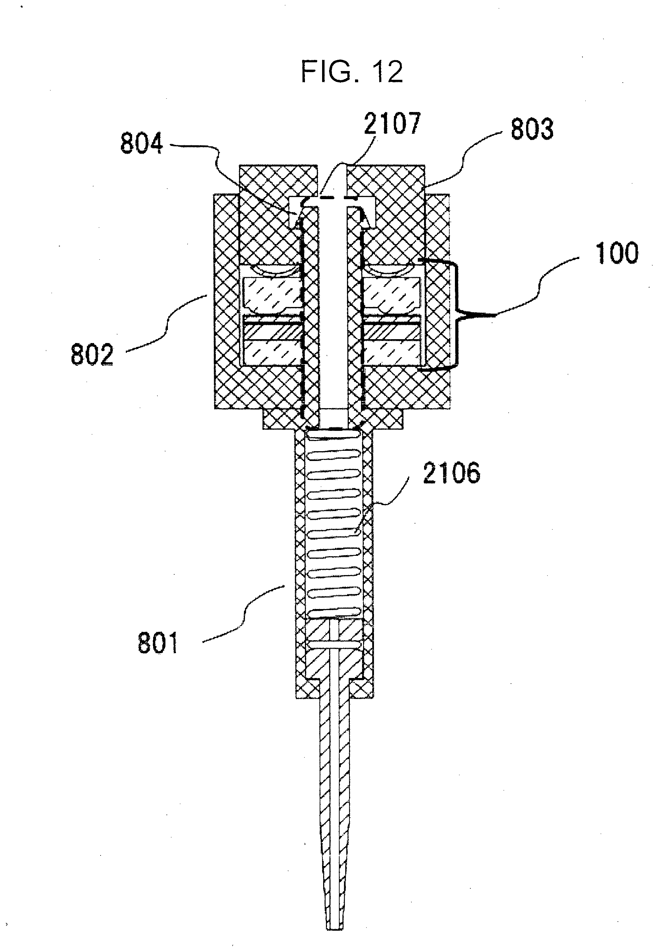

Fig. 12 is a sectional view illustrating the details of the suction conveyance device 1101. The suction conveyance device 1101 includes, at the tip end thereof, a buffer-spring-2106-equipped suction nozzle 801. The buffer spring 2106 is an example of an elastic body that mitigates the impact force upon an electronic component landing on a land.

A suction nozzle attachment/detachment section 802 is a housing inside which the press sensor 100 is stored. The press sensor 100 described in at least one of Embodiments 1 to 4 is arranged within the suction nozzle attachment/detachment section 802. A press sensor fixing fitting 803 for substantially fixing the press sensor 100 fixes the press sensor 100 from the opposite side of the side on which the suction nozzle 801 is connected. The press sensor 100 is arranged at substantially a nozzle end section, on the opposite side of the tip end for holding of a component by the suction nozzle 801.

The suction nozzle attachment/detachment section 802, the press sensor 100, and the press sensor fixing fitting 803 are formed with an opening 2107 penetrating therethrough. Upon assembly, a worker inserts the nozzle end section of the buffer-spring-equipped suction nozzle 801 into the opening 2107 and fixes the buffer-spring-equipped suction nozzle 801 to the suction nozzle attachment/detachment section 802 with a suction nozzle fixing pin 804.

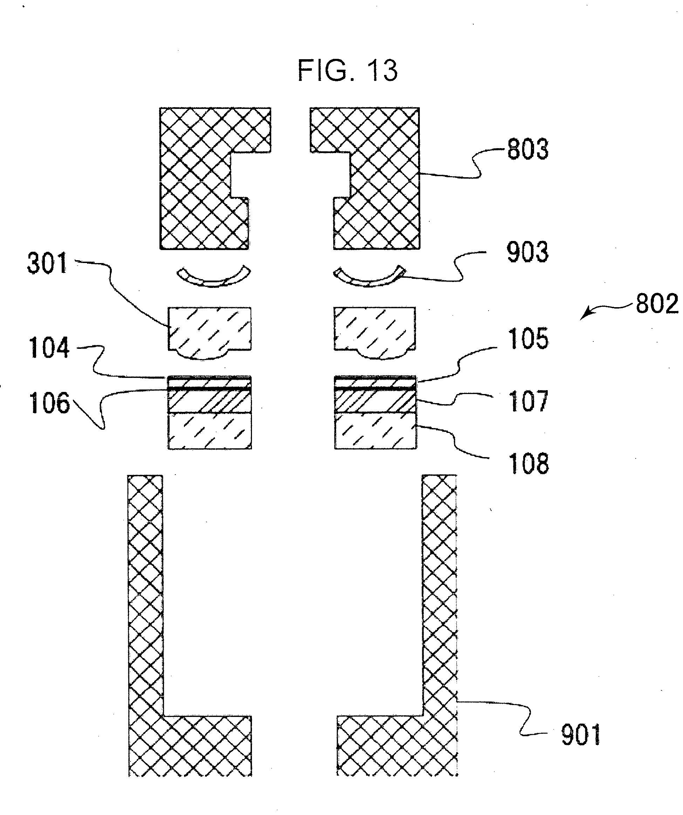

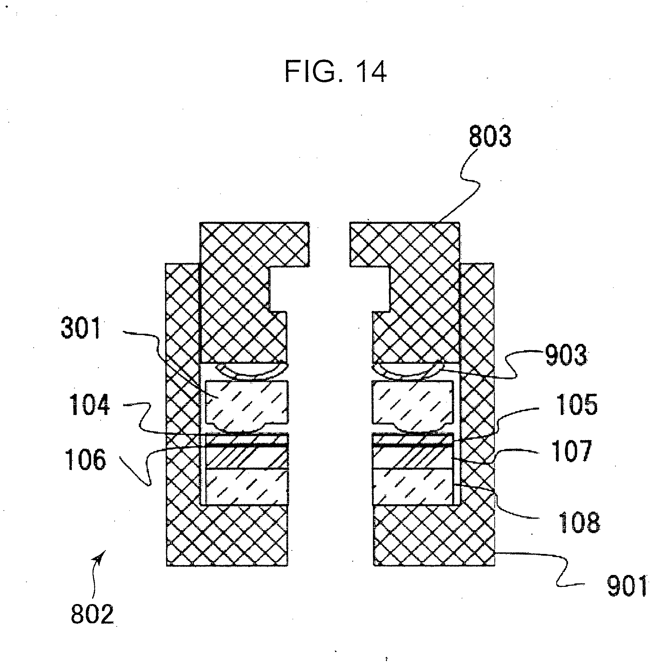

The suction nozzle attachment/detachment section 802 is configured of eight types of components shown in Fig. 13 and assembled as in Fig. 14 for use. First, the component configuration will be described using Fig. 13. The suction nozzle attachment/detachment section 802 includes the pressing jig 301, a fixing spring 903 for pushing the pressing jig 301 against the piezoelectric film 105, the upper electrode 104 and the lower electrode 106 for extracting output from the piezoelectric film 105, the low-rigidity plate 107 that assists deformation of the piezoelectric film 105, the piezoelectric film 105, the high-rigidity plate 108 with a higher rigidity than the low-rigidity plate 107 to support the low-rigidity plate 107, and a press sensor holder 901 that positions and holds them. The press sensor fixing fitting 803 is attached in a fixed manner to the press sensor holder 901. The suction nozzle attachment/detachment section 802 is in some cases substantially molded integrally with the configuration mentioned above.

By a worker, upon assembling these, the high-rigidity plate 108, the low-rigidity plate 107, the lower electrode 106, the piezoelectric film 105, the upper electrode 104, the pressing jig 301, and the fixing spring 903 are put in order into the press sensor holder 901 and fixed with the fixing pin 804 of the buffer-spring-equipped suction nozzle as in Fig. 12. As an assembly method, a conceivable method of assembly is to utilize a pin, groove, or the like such that the press sensor holder 901 does not fall from the press sensor fixing fitting 803, while the press sensor holder 901 of Fig. 14 is made movable in the vertical direction with respect to the press sensor fixing fitting 803.

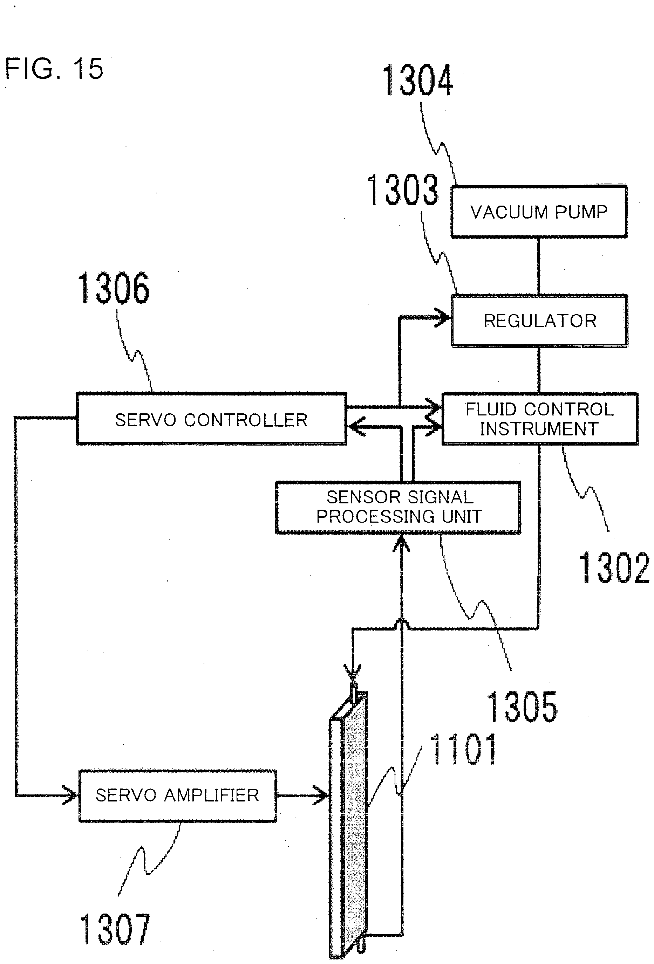

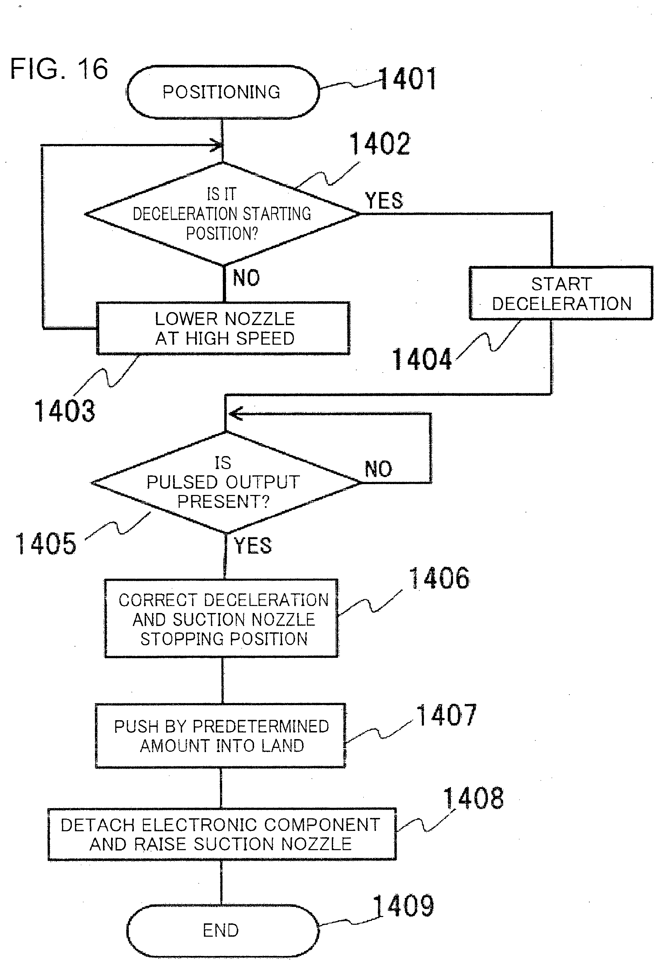

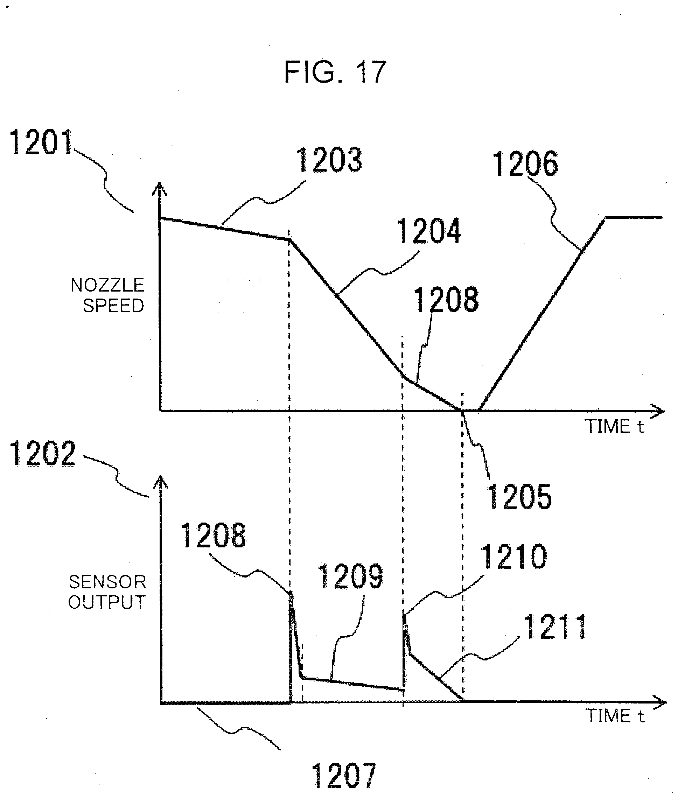

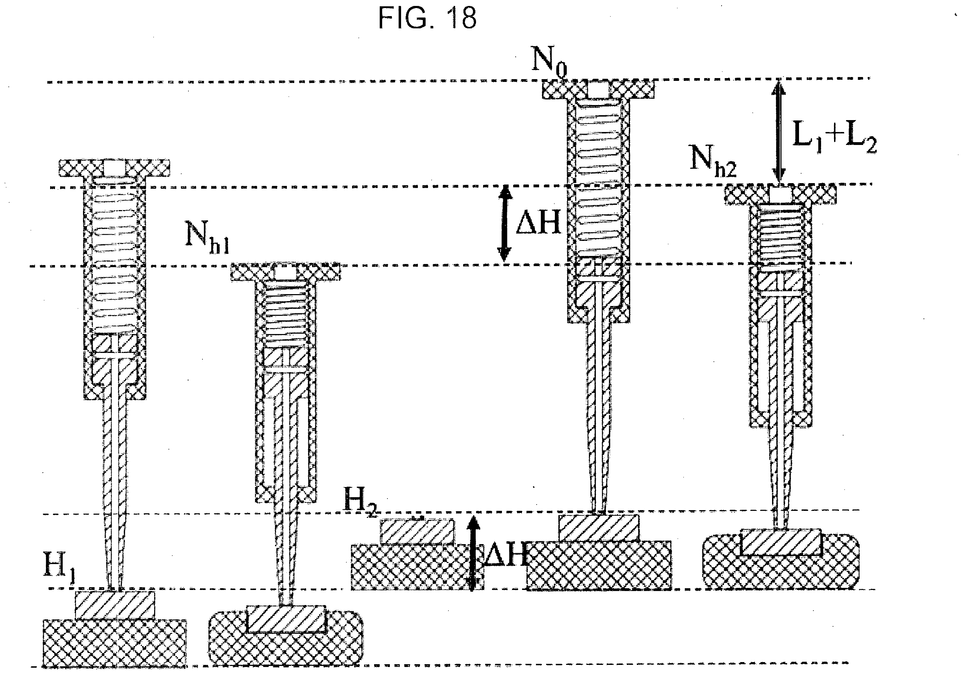

Next, using Fig. 15 to Fig. 18, component mounting in this embodiment will be described. Fig. 15 is a block diagram schematically showing peripheral devices for operating the suction conveyance device 1101. Fig. 16 is a flowchart of component mounting. Fig. 17 is a timing chart showing the relation of the speed of the suction nozzle 801 and the output from the press sensor 100 with respect to time. In a lower section 1202 of Fig. 17, a timing chart of the output of the press sensor synchronized with a timing chart of the suction nozzle 801 is shown. That is, the abscissas in both upper and lower charts of Fig. 17 represent the flow of time from a state in which the suction nozzle 801 has been lowered to near the estimated land height and started deceleration, up to a raising step in which the suction nozzle 801 leaves an electronic component on a land and returns to a height that allows horizontal movement. Fig. 18 is a view illustrating $H_1$, $H_2$, $\Delta H$, $N_{h1}$, $N_0$, and $N_{h2}$ described later.

As shown in Fig. 15, peripheral devices of the suction conveyance device 1101 include a sensor signal processing unit 1305, a servo controller 1306, a servo amplifier 1307, a fluid control instrument 1302, a regulator 1303, and a vacuum pump 1304. At least one of the sensor signal processing unit 1305, the servo controller 1306, the servo amplifier 1307, and the fluid control instrument 1302 is in some cases substantially included in the processing unit 2104 mentioned earlier.

First, the suction conveyance device 1101 is positioned on a land (step 1401 of Fig. 16). With a linear actuator of the suction conveyance device 1101, the suction nozzle 801 onto which an electronic component has been suctioned is caused to approach the land at a predetermined speed (first speed $V_1$). Based on a predetermined estimated land height $H_1$, the sensor signal processing unit 1305 determines, from the output from an encoder of the linear actuator, whether or not the suction nozzle 801 has been lowered to a deceleration starting position set in advance (step 1402 of Fig. 16).

In the case where the sensor signal processing unit 1305 has determined that the suction nozzle 801 has reached the deceleration starting position (YES in step 1402), the servo controller 1306 transmits a command signal to the linear actuator via the servo amplifier 1307 to decelerate the first speed of the suction nozzle 801. As a result, deceleration of the suction nozzle 801 starts, and the first speed is changed to a second speed $V_2$ slower than the first speed (step 1404 of Fig. 16, reference sign 1203 of Fig. 17).

In the case where the sensor signal processing unit 1305 has determined that the suction nozzle 801 is yet to reach the deceleration starting position (No in step 1402), approaching of the suction nozzle to the land at the first speed $V_1$ is maintained (step 1403 of Fig. 16).

The output of the press sensor 100 thus far is zero, as shown by reference sign 1207 of Fig. 17. When the suction nozzle 801 approaches the land at the second speed $V_2$, and the electronic component held at the tip end contacts the land, a minute first impact force is generated. In that case, a pulsed signal (first signal) is output (reference sign 1208 of Fig. 17) from the press sensor 100. By determining the presence or absence of the pulsed signal, the sensor signal processing unit 1305 detects landing of the electronic component on the land (step 1405 of Fig. 16). In the case where the sensor signal processing unit 1305 has detected a pulsed signal from the press sensor 100, the sensor signal processing unit 1305 recognizes, as an actual land height $H_2$, the height at which the pulsed signal has been detected. Information of the actual land height $H_2$ is transmitted to the servo controller 1306. Thereupon, the sensor signal processing unit 1305 obtains information of a height $N_0$ of the suction nozzle 801.

The servo controller 1306 changes a first stopping height $N_{h1}$ of the suction nozzle 801 set in advance to a second stopping height $N_{h2}$. More specifically, it can be expressed as $N_{h2} = N_0 - (L_1 + L_2)$, where the amount of compression of the buffer spring 2106 is $L_1$, and the amount of pushing is $L_2$.

Further, the servo controller 1306 obtains information of the deceleration for stopping the suction nozzle 801 at the second stopping height $N_{h2}$. The deceleration is acceleration acting in the negative direction, in the case where the direction of the suction nozzle 801 approaching the land is taken as a positive direction. The deceleration is determined such that the suction nozzle 801 starts to decelerate from the height $N_0$ and that substantially $V_2 = 0$ at the second stopping height $N_{h2}$ (step 1406 of Fig. 16). Step 1406 is a step of obtaining at least one of (or desirably both) information of the stopping height position of the suction nozzle 801 and information of the deceleration, using a pulsed signal from the press sensor 100.

The speed upon pushing the electronic component from the actual land height $H_2$ is shown by reference sign 1204 of Fig. 17. Upon a substantial full compression of the buffer spring 2106, a second impact force is generated in some cases. The second impact force is in some cases output from the press sensor 100, as a pulsed signal (second signal, reference sign 1210 of Fig. 17) smaller than the first signal.

After step 1406, the servo controller 1306 drives the linear actuator to push the electronic component suctioned onto the tip end of the suction nozzle 801 into the land by the amount of pushing $L_1$ (step 1407 of Fig. 16). The sensor output while the electronic component is being pushed is shown by reference sign 1211 of Fig. 17. After step 1407, the nozzle speed becomes zero, as shown by reference sign 1205 of Fig. 17.

Then, the servo controller 1306 stops the linear actuator, cuts off the negative pressure of the suction nozzle 801 to detach the electronic component, and raises the suction nozzle 801 with the linear actuator (step 1408). The speed at the time of raising is shown by reference sign 1206 of Fig. 17. In the case where the suction nozzle 801 has been raised to a predetermined position, mounting of the component is terminated (step 1409 of Fig. 16). The detachment/attachment of the electronic component is performed by the fluid control instrument 1302 controlling the vacuum pump 1304 and the regulator 1303 to adjust the pressure.

With this embodiment, it is possible to detect a minute impact force with the press sensor 100. Thus, it can be expressed that this embodiment brings about at least one of the following effects. (1) A minute impact force applied to the suction nozzle 801 can be detected, and damage to a minute component suctioned onto the suction nozzle 801 can be prevented. (2) A detection device allows for a compact configuration, and therefore an increase in size of the device can be suppressed. (3) The detection device allows for a lightweight configuration and therefore does not adversely affect the positioning precision of the suction nozzle.

<Embodiment 6>

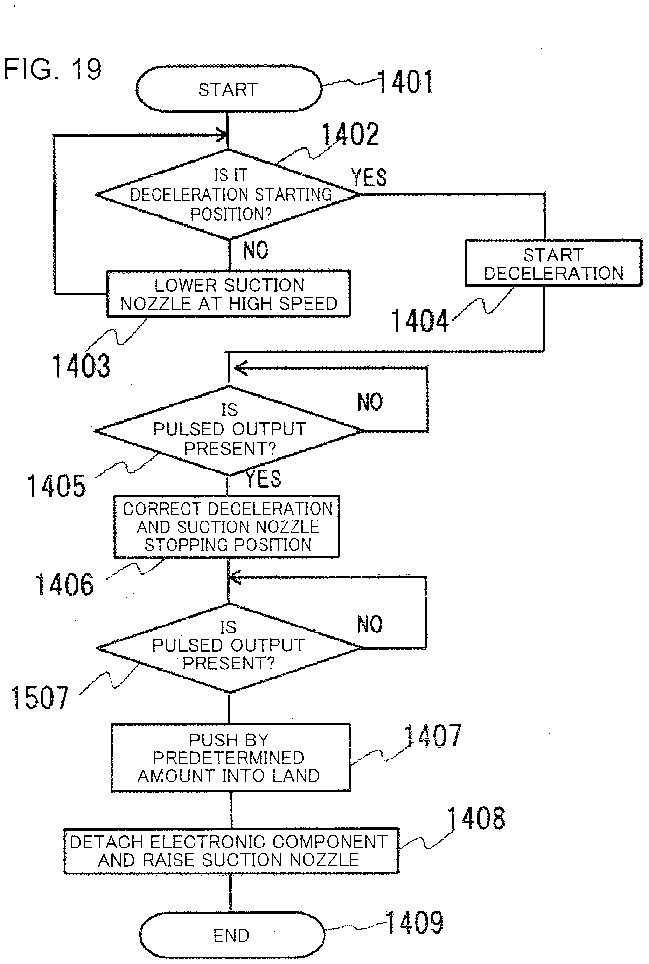

Next, Embodiment 6 will be described using Fig. 19. Fig. 19 is a flowchart for illustrating Embodiment 6.

Fig. 19 is a flowchart illustrating the operation from positioning of the suction nozzle 801 on a predetermined land until termination of mounting, in a similar manner to Embodiment 5. In Embodiment 6, there is added step 1507 of more accurately controlling an amount of pushing 1508 of an electronic component into the land, using a pulsed signal (second signal, reference sign 1210 of Fig. 17) emitted from the press sensor 100 when the buffer spring 2106 has substantially fully compressed, in order to further enhance the positioning precision.

More specifically, in step 1507, detection of the second signal triggers a change from a change of speed shown by reference sign 1204 to a change of speed shown by reference sign 1208. That is, this embodiment can be expressed as including a step of changing the deceleration determined in step 1406 of Embodiment 5. With this embodiment, the position precision is determined with a higher precision.

<Embodiment 7>

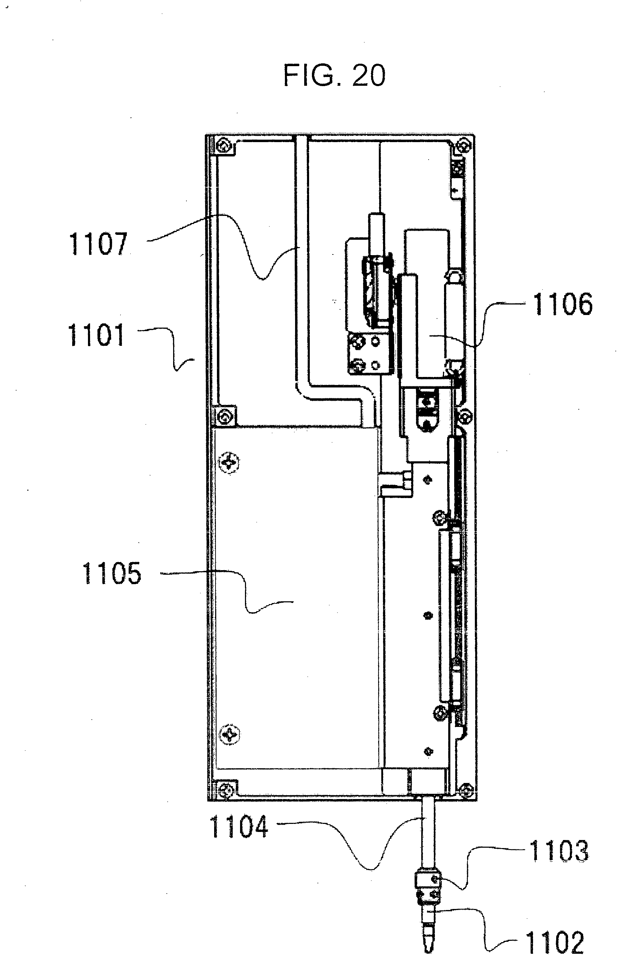

Next, Embodiment 7 will be described using Fig. 20. Fig. 20 is a side view of the suction conveyance device 1101 according to Embodiment 7. The suction conveyance device 1101 includes a linear actuator 1105 for the Z-direction, a buffer-spring-equipped suction nozzle 1102, and a rotary actuator 1106 that adjusts the angle of a suctioned electronic component.

In this embodiment, the route of vertical movement of the buffer-spring-equipped suction nozzle 1102 substantially passes through the center of rotation of the buffer-spring-equipped suction nozzle 1102. That is, the axis for vertical movement of the buffer-spring-equipped suction nozzle 1102 substantially coincides with the axis for rotation of the buffer-spring-equipped suction nozzle 1102.

The suction conveyance device 1101 is moved on a substrate by the x-beam 2102 and the γ-beam 2103 in a similar manner to Embodiment 5, positions an electronic component suctioned onto the tip end of the buffer-spring-equipped suction nozzle 1102 on a predetermined land, and then is lowered by the linear actuator 1105 to attach the electronic component to the land.

The press sensor 100 described in at least one of Embodiments 1 to 4 is incorporated, as in Fig. 8, in the suction nozzle attachment/detachment section 1103 at the tip end of a shaft 1104 of the suction conveyance device 1101 to generate an electric charge proportional to the differential of the force applied to the buffer-spring-equipped suction nozzle 1102 and output a pulsed signal. The suction conveyance device 1101 of this embodiment also determines landing of an electronic component on a land based on a pulsed signal.

The attachment/detachment of an electronic component suctioned onto the tip end of the buffer-spring-equipped suction nozzle 1102 is performed by switching of negative pressure and positive pressure supplied from a vacuum suction flow path 1107 linked to control of the linear actuator.

With this embodiment, freedom upon mounting a component is further enhanced, since the axis for vertical movement of the buffer-spring-equipped suction nozzle 1102 substantially coincides with the axis for rotation of the buffer-spring-equipped suction nozzle 1102.

Embodiments of the present invention have been described above, but the present invention is not limited to the above descriptions. A task or effect of the present invention can be discussed apart from making the impact force minute. For example, Patent Literature 2 and Patent Literature 3 disclose incorporating a strain sensor in a suction nozzle. However, since a strain sensor is relatively heavy, wobble upon the suction nozzle stopping from high-speed movement in the horizontal direction increases, and the positioning precision decreases. By attaching the sensor, installation intervals of a plurality of mounted suction nozzles increase, resulting in other undesirable phenomena in some cases, such as an increase in size of a device. Therefore, for high-speed component mounting machines, there is a demand for a small and lightweight sensor that does not adversely affect the performance of a device even when incorporated within a suction nozzle or in a portion where a suction nozzle is attached/detached.

Since a detection sensor of the present invention is small and lightweight, it can be expressed that at least one of the following effects is brought about. (1) A detection device allows for a compact configuration, and therefore an increase in size of the device can be suppressed. (2) The detection device allows for a lightweight configuration and therefore does not adversely affect the positioning precision of a suction nozzle.

**Claims**

1. A component mounting device comprising:

    a nozzle (801) for conveying a component (1605);
    a detection device (100) that outputs a pulsed first signal indicating landing of the component; and
    a processing unit (1305),
    the detection device (100) including a piezoelectric body (105), wherein the piezoelectric body (105) is configured to generate an electric charge when the piezoelectric body (105) is deformed, and
    the processing unit (1305) acquiring, based on the first signal output from the detection device (100), at least one of information of deceleration of the nozzle (801) and information of a stopping position of the nozzle (801), **characterized in that**:

        the detection device (100) includes a first plate (107) and a second plate (108) with a higher rigidity than the first plate, and the piezoelectric body (105), the first plate (107), and the second plate (108) form a laminated structure in which the first plate (107) is arranged on a lower surface side of the piezoelectric body (105) and the second plate (108) is arranged on a lower surface side of the first plate (107).

2. The component mounting device according to claim 1,
further comprising a holder (901, 802) that stores the laminated structure body including the piezoelectric body (105), the first plate (107) and the second plate (108) to position and hold them.

3. The component mounting device according to claim 2, further comprising:

    an opening (2107) penetrating through the laminated structure body and the holder (901 ,802), and
    a pin (804) fixing the nozzle (801) to the holder (901 802) in the opening (2107).

4. The component mounting device according to any one of claims 1 to 3, further comprising a pressing section (302) that presses a part of the piezoelectric body (105) from an upper surface side of the piezoelectric body (105).

5. The component mounting device according to claim 4, wherein the pressing section (302) is a projection or a recess.

6. The component mounting device according to claim 5, further comprising an elastic body (2106) that mitigates an impact force upon landing of the component,
wherein the processing unit (1305) changes the deceleration based on a pulsed second signal output from the detection device (100) when the elastic body has been fully compressed.

7. The component mounting device according to claim 1, further comprising an elastic body (2106) that mitigates an impact force upon landing of the component,
wherein the processing unit (1305) changes the deceleration based on a pulsed second signal output from the detection device (100) when the elastic body has been fully compressed.

**Patentansprüche**

1. Eine Vorrichtung zur Montage von Komponenten, die Folgendes umfasst:

    eine Düse (801) zum Fördern einer Komponente (1605);
    eine Erfassungsvorrichtung (100), die ein gepulstes erstes Signal ausgibt, das das Landen der Komponente angibt; und
    eine Verarbeitungseinheit (1305),
    wobei die Erfassungsvorrichtung (100) einen piezoelektrischen Körper (105) beinhaltet, wobei der piezoelektrische Körper (105) konfiguriert ist, um eine elektrische Ladung zu erzeugen, wenn der piezoelektrische Körper (105) verformt wird, und
    wobei die Verarbeitungseinheit (1305), basierend auf dem ersten Signal, das von der Erfassungsvorrichtung (100) ausgegeben wird, mindestens eine der Informationen über eine Verzögerung der Düse (801) und über eine Halteposition der Düse (801) erfasst, **dadurch gekennzeichnet, dass:**

    die Erfassungsvorrichtung (100) eine erste Platte (107) und eine zweite Platte (108) mit einer höheren Steifigkeit als die erste Platte beinhaltet, und dass
    der piezoelektrische Körper (105), die erste Platte (107) und die zweite Platte (108) eine laminierte Struktur bilden, in der die erste Platte (107) auf einer unteren Oberflächenseite des piezoelektrischen Körpers (105) und die zweite Platte (108) auf einer unteren Oberflächenseite der ersten Platte (107) angeordnet ist.

2. Die Vorrichtung zur Montage von Komponenten nach Anspruch 1, die ferner einen Halter (901, 802) umfasst, der den laminierten Strukturkörper einschließlich des piezoelektrischen Körpers (105), der ersten Platte (107) und der zweiten Platte (108) speichert, um sie zu positionieren und zu halten.

3. Die Vorrichtung zur Montage von Komponenten nach Anspruch 2, die ferner Folgendes umfasst:

    eine Öffnung (2107), die durch den laminierten Strukturkörper und den Halter (901, 802) hindurchgeht, und
    einen Stift (804), der die Düse (801) am Halter (901, 802) in der Öffnung (2107) befestigt.

4. Die Vorrichtung zur Montage von Komponenten nach irgendeinem der Ansprüche von 1 bis 3, die ferner einen Press-Abschnitt (302) umfasst, der einen Teil des piezoelektrischen Körpers (105) von einer oberen Oberflächenseite des piezoelektrischen Körpers (105) aus drückt.

**5.** Die Vorrichtung zur Montage von Komponenten nach Anspruch 4, wobei der Press-Abschnitt (302) ein Vorsprung oder eine Aussparung ist.

**6.** Die Vorrichtung zur Montage von Komponenten nach Anspruch 5, die ferner einen elastischen Körper (2106) umfasst, der eine Aufprallkraft beim Landen des Bauteils mildert,
wobei die Verarbeitungseinheit (1305) die Verzögerung ändert, basierend auf einem gepulsten zweiten Signal, das von der Erfassungsvorrichtung (100) ausgegeben wird, wenn der elastische Körper vollständig komprimiert wurde.

**7.** Die Vorrichtung zur Montage von Komponenten nach Anspruch 1, die ferner einen elastischen Körper (2106) umfasst, der eine Aufprallkraft beim Landen des Bauteils mildert,
wobei die Verarbeitungseinheit (1305) die Verzögerung ändert, basierend auf einem gepulsten zweiten Signal, das von der Erfassungsvorrichtung (100) ausgegeben wird, wenn der elastische Körper vollständig komprimiert wurde.

**Revendications**

**1.** Un dispositif de montage de composants comprenant :

une buse (801) pour transporter un composant (1605) ;
un dispositif de détection (100) qui émet un premier signal à impulsions indiquant l'atterrissage du composant ; et
une unité de traitement (1305),
le dispositif de détection (100) incluant un corps piézoélectrique (105), sachant que le corps piézoélectrique (105) est configuré pour générer une charge électrique lorsque le corps piézoélectrique (105) est déformé, et
l'unité de traitement (1305) acquérant, sur la base du premier signal émis par le dispositif de détection (100), au moins une information parmi une information de décélération de la buse (801) et une information de position d'arrêt de la buse (801),

**caractérisé en ce que** :

le dispositif de détection (100) inclut une première plaque (107) et une deuxième plaque (108) ayant une rigidité plus élevée que la première plaque, et que
le corps piézoélectrique (105), la première plaque (107) et la deuxième plaque (108) forment une structure stratifiée dans laquelle la première plaque (107) est disposée sur un côté de surface inférieure du corps piézoélectrique (105) et la deuxième plaque (108) est disposée sur un côté de surface inférieure de la première plaque (107).

**2.** Le dispositif de montage de composants d'après la revendication 1, comprenant en outre un élément de maintien (901, 802) qui stocke le corps de structure stratifié comprenant le corps piézoélectrique (105), la première plaque (107) et la deuxième plaque (108) pour les positionner et les maintenir.

**3.** Le dispositif de montage de composants d'après la revendication 2, comprenant en outre :

une ouverture (2107) traversant le corps de la structure stratifiée et l'élément de maintien (901, 802), et
une broche (804) fixant la buse (801) sur l'élément de maintien (901, 802) dans l'ouverture (2107).

**4.** Le dispositif de montage de composants d'après l'une quelconque des revendications de 1 à 3, comprenant en outre une section de pressage (302) qui presse une partie du corps piézoélectrique (105) depuis une face supérieure du corps piézoélectrique (105).

**5.** Le dispositif de montage de composants d'après la revendication 4, sachant que la section de pressage (302) est une saillie ou un évidement.

**6.** Le dispositif de montage de composants d'après la revendication 5, comprenant en outre un corps élastique (2106) qui atténue une force d'impact lors de l'atterrissage du composant,
sachant que l'unité de traitement (1305) modifie la décélération sur la base d'un deuxième signal à impulsions délivré par le dispositif de détection (100) lorsque le corps élastique a été complètement comprimé.

**7.** Le dispositif de montage de composants d'après la revendication 1, comprenant en outre un corps élastique (2106) qui atténue une force d'impact lors de l'atterrissage du composant,
sachant que l'unité de traitement (1305) modifie la décélération sur la base d'un deuxième signal à impulsions délivré par le dispositif de détection (100) lorsque le corps élastique a été complètement comprimé.

FIG. 1A    FIG. 1B    FIG. 1C    FIG. 1D    FIG. 1E

# FIG. 2

1701

1702

1703

1801

1803　　　1802　　1803　　　　　1802

FIG. 3A　　　　　　　　FIG. 3B

## FIG. 4A

## FIG. 4B

FIG. 5A

FIG. 5B

FIG. 6A

FIG. 6B

FIG. 7A

301

302

104

105

106

107

108

FIG. 7B

301

302

104

105

106

107

408

108

# FIG. 8

FIG. 9A

502

IXB - - - - - IXB

101

102

FIG. 9B

102                    501

502
104
105
106
107
108

FIG. 10A

501
502
104
106
105
107
108

FIG. 10B

501
502
104
106
608
105
107
108

# FIG. 11

# FIG. 12

## FIG. 13

FIG. 14

FIG. 15

1304

1303

VACUUM PUMP

1306

REGULATOR

SERVO CONTROLLER

FLUID CONTROL
INSTRUMENT

SENSOR SIGNAL
PROCESSING UNIT

1302

1305

1101

SERVO AMPLIFIER

1307

FIG. 16

POSITIONING —— 1401

IS IT
DECELERATION STARTING
POSITION? —— 1402

YES → START
DECELERATION —— 1404

NO

LOWER NOZZLE
AT HIGH SPEED —— 1403

IS
PULSED OUTPUT
PRESENT? —— 1405

NO

YES

CORRECT DECELERATION
AND SUCTION NOZZLE
STOPPING POSITION —— 1406

PUSH BY PREDETERMINED
AMOUNT INTO LAND —— 1407

DETACH ELECTRONIC COMPONENT
AND RAISE SUCTION NOZZLE —— 1408

END —— 1409

# FIG. 17

NOZZLE
SPEED

TIME t

SENSOR
OUTPUT

TIME t

FIG. 18

EP 3 082 390 B1

FIG. 19

START 1401

1402
IS IT DECELERATION STARTING POSITION?

YES → START DECELERATION 1404

NO

LOWER SUCTION NOZZLE AT HIGH SPEED

1403

1405
IS PULSED OUTPUT PRESENT?

NO

YES

CORRECT DECELERATION AND SUCTION NOZZLE STOPPING POSITION

1406

1507
IS PULSED OUTPUT PRESENT?

NO

PUSH BY PREDETERMINED AMOUNT INTO LAND 1407

DETACH ELECTRONIC COMPONENT AND RAISE SUCTION NOZZLE 1408

END 1409

# FIG. 20

1107

1101

1106

1105

1104

1103

1102

**EP 3 082 390 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2012174751 A
- JP H5288618 B
- JP H5304395 B
- US 5285946 A
- US 2009199658 A1